# EUROPÄISCHE PATENTSCHRIFT

(11) **EP 1 088 386 B1**
(45) Veröffentlichungstag und Bekanntmachung des Hinweises auf die Patenterteilung: **14.08.2002**
(21) Anmeldenummer: 99929245.1
(22) Anmeldetag: 16.06.1999
(51) Int. Cl.: H02M 1/088, H02M 1/00, H02M 7/48, H01L 25/07

(54) **HALBBRÜCKENBAUGRUPPE**
HALF BRIDGE MODULE
BLOC DE COMPOSANTS A DEMI-PONT

(30) Priorität: 16.06.1998 DE 19826731
(43) Veröffentlichungstag der Anmeldung: 04.04.2001
(73) Patentinhaber: Continental ISAD Electronic Systems GmbH & Co. oHG, 86899 Landsberg/Lech (DE)
(72) Erfinder: GRÜNDL, Andreas, D-81377 München (DE); HOFFMANN, Bernhard, D-82319 Starnberg (DE)
(74) Vertreter: Schmidt, Steffen J., Dipl.-Ing.
(86) Internationale Anmeldenummer: EP9904176
(87) Internationale Veröffentlichungsnummer: WO9966629

(56) Entgegenhaltungen:
- EP-A- 0 469 172
- EP-A- 0 553 981
- DE-C- 4 230 510
- US-A- 5 132 896

## Beschreibung

Die Erfindung betrifft eine Halbbrückenbaugruppe zum Schalten elektrischer Leistungen, die in einem eine elektrisch isolierende Kühlflüssigkeit enthaltenden Gehäuse angeordnet ist, und bei der wenigstens zwei Halbleiterschalter unter Bildung einer Halbbrücke in Serie geschaltet sind. Dabei weist jeder Halbleiterschalter einen Steuereingang zur Verbindung mit einer Ansteuereinrichtung auf. Der erste Halbleiterschalter ist mit seinem Source-Anschluß mit einem hohen Spannungspotential verbindbar und der zweite Halbleiterschalter ist mit seinem Drain-Anschluß mit einem niedrigen Spannungspotential verbindbar. Zur Bildung eines Ausgangs ist der Drain-Anschluß jedes ersten Halbleiterschalters mit dem Source-Anschluß des jeweiligen zweiten Halbleiterschalters verbunden. Außerdem ist wenigstens eine Kondensatoranordnung zwischen dem hohen und dem niedrigen Spannungspotential angeordnet. Eine solche Halbbrückenbaugruppe ist aus der DE-A-42 30 510 bekannt.

Derartige Halbbrückenanordnungen sind zur Bildung von Wechselrichtern für die unterschiedlichsten Anwendungsbereiche, z.B. zur Speisung von Drehfeldmaschinen, Permanentmagnetmotoren und dergl. im Einsatz (siehe z.B. auch die DE-A-40 27 969).

Aus der US-PS 5,132,896 ist eine Wechselrichteranordnung bekannt, die zur Verringerung der Wirkung verteilter Induktivitäten der Leiter, die zum Verbinden der Kondensatoren und der Halbleiterschalter verwendet werden, plattenförmige Zuleitungen mit großer Fläche aufweist. Dadurch werden große Dämpfungskondensatoren zur Kompensation der Leitungsinduktivitäten vermieden. Außerdem kann durch die großflächige Gestaltung der plattenförmigen Zuleitungen die Wärmeabstrahlung verbessert werden. Des weiteren sind die plattenförmigen Zuleitungen so gestaltet, daß die Größe und die Richtung des Stromflusses durch die plattenförmigen Zuleitungen die Wirkung der verteilten Induktivitäten minimieren.

Allerdings dienen bei dieser Wechselrichteranordnung die größflächigen Zuleitungen lediglich der Minderung von Störinduktivitäten und sind als Zuleitungen zu großen Elektrolytkondensatoren eingesetzt.

Um die Leistungsdichte der eingangs beschriebenen Halbbrückenbaugruppe weiter zu steigern, und um sie insbesondere für die Großserieneinsatz noch geeigneter zu gestalten, ist sie dahin gehend weitergebildet, daß jeweilige erste Halbleiterschalter mit ihrem Source-Anschluß auf einer gemeinsamen ersten, mit dem hohen Spannungspotential verbindbaren metallischen Leiterschiene angeordnet sind und jeweilige zweite Halbleiterschalter mit ihrem Source-Anschluß auf einer gemeinsamen zweiten, den Ausgang bildenden metallischen Leiterschiene angeordnet sind, wobei die zweite Leiterschiene im Abstand zur ersten Leiterschiene neben dieser angeordnet ist. Weiterhin ist jeder zweite Halbleiterschalter mit seinem Drain-Anschluß mit einer gemeinsamen dritten, mit dem niedrigen Spannungspotential verbindbaren metallischen Leiterschiene verbunden, die im Abstand zu und neben der ersten und der zweiten Leiterschiene angeordnet. Die Kondensatoranordnung weist einen mit der ersten und der dritten Leiterschiene durch Anschlüsse verbundenen Stützkondensator auf, der den ersten und zweiten Halbleiterschalter derart übergreift, daß sich die Halbleiterschalter räumlich zwischen den entsprechenden Leiterschienen und dem Stützkondensator befinden. Außerdem weist der Steuereingang einen Anschluß zur Verbindung mit der Ansteuereinrichtung im Bereich einer ersten Stirnseite der Leiterschienen auf, und der Ausgang weist einen Anschluß zur Verbindung mit einem elektrischen Verbraucher im Bereich einer der ersten gegenüberliegenden, zweiten Stirnseite der zweiten Leiterschiene auf.

Durch den erfindungsgemäßen Aufbau der Halbbrückenbaugruppe wird eine besonders kompakte Anordnung erreicht, die eine mit bisherigen Lösungen nicht vergleichbare Packungsdichte ermöglicht. Damit kann sowohl das erforderliche Volumen an Kühlflüssigkeit bezogen auf das Gesamtvolumen gering gehalten werden, als auch eine Miniaturisierung der Gesamtanordnung erreicht werden, die einen Einsatz der Erfindung auch in mobilen Anwendungen sehr wirtschaftlich werden läßt. Dabei spielt auch eine erhebliche Rolle, daß durch den die dritte Dimension ausnutzenden Aufbau eine räumliche Trennung der Leistung führenden Leitungen (bzw. Leiterschienen) und Anschlüsse einerseits und der Ansteuerleitungen andererseits ermöglicht ist. Dies führt zu einer erheblich erhöhten Störsicherheit. Ein weiterer wesentlicher Gesichtspunkt der Erfindung ist der modulare Aufbau, der eine problemlose Erweiterung und Anpassung der Halbbrückenbaugruppe an die jeweiligen Anforderungen erlaubt.

Bei einer bevorzugten Ausführungsform sind die Halbleiterschalter durch schnellschaltende, verlustarme Feldeffekt-Transistoren (FETs) oder durch schnellschaltende, verlustarme bipolare Transistoren mit isoliertem Gateanschluß (IGBTs) gebildet. Dabei können insbesondere MOS-FETs mit integrierten Freilaufdioden oder zu den Transistoren parallel geschaltete zusätzliche externe Freilaufdioden eingesetzt werden. Diese externen Freilaufdioden sind vorteilhaft in gleicher Weise wie die Halbleiterschalter und in unmittelbarer Nähe zu diesen auf einer der Leiterschienen angeordnet.

Insbesondere zur mechanischen und elektrischen Parallelschaltung mehrerer Halbbrückenbaugruppen sind an der ersten und der dritten Leiterschiene elektrische leitende Abstandshalter angeordnet. Damit können gleichartige Halbbrükkenbaugruppen starr miteinander gekoppelt werden und gleichzeitig die Zuführung der hohen und niedrigen Potentiale an alle derart gekoppelten Halbbrückenbaugruppen auf einfache Weise erreicht werden. Die Abstandshalter sind in einer ersten Ausführungsform der Erfindung als separate Bauteile realisiert, mit denen die jeweiligen Leiterschienen verbunden (verschraubt, vernietet, verschweißt etc.) sind. Alternativ dazu können die Abstandshalter auch mit den Leiterschienen einstückig sein, so daß der erforderliche Abstand zwischen den einzelnen Halbbrückenbaugruppen durch unmittelbares Zusammenfügen der jeweiligen Leiterschienen zustandekommt und auch genau eingehalten ist.

In einer bevorzugten Ausführungsform der Erfindung sind die erste, zweite und dritte Leiterschiene durch eine elektrisch isolierende Trägerplatine mechanisch miteinander fest verbunden. Alternativ dazu können die erste, zweite und dritte Leiterschiene durch elektrisch isolierende Stege, die zwischen den einzelnen Leiterschienen angeordnet sind, mechanisch miteinander fest verbunden sein. Die Trägerplatine kann auch zur Aufnahme von Leiterbahnen dienen, um den Halbleitern Steuersignale zuzuführen, oder um Test- oder Mess-Stellen herauszuführen. Die Trägerplatine dient auch dazu, Verbindungsleitungen zwischen den jeweiligen Steuereingängen der Halbleiterschalter und dem Anschluß zur Verbindung mit der Ansteuereinrichtung aufzunehmen.

Vorzugsweise ist dabei die Trägerplatine mit Aussparungen versehen, die so bemessen sind, daß die auf den Leiterschienen direkt aufgebrachten Halbleiter (Transistoren und Dioden) zumindest mit ihren Kontaktierungsstellen freiliegen, also nicht durch die Trägerplatine verdeckt sind. Dies bewirkt, daß die effektive Bauhöhe der Halbleiter und der Trägerplatine sich nicht addieren. Vielmehr sind beide mit den Leiterschienen direkt (auf gleichem Niveau) verbunden. Die Trägerplatine dient damit sowohl der mechanischen Verbindung der Leiterschienen untereinander als auch der elektrischen Leitungsführung. Die Verbindung der auf der Trägerplatine angeordneten Leiterbahnen mit den Kontaktierungsstellen der Halbleiter wird vorzugsweise durch Bond-Drähte hergestellt.

Alternativ dazu kann anstelle der Trägerplatine an den Leiterschienen eine elektrisch isolierende Folie mit Verbindungsleitungen zwischen den jeweiligen Steuereingängen und dem Anschluß zur Verbindung mit der Ansteuereinrichtung angeordnet sein. Da eine Folie nicht geeignet ist, eine mechanisch starre oder feste Verbindung zwischen den einzelnen Leiterschienen herzustellen, muß außerdem zum Herstellen der notwendigen Festigkeit der Leiterschienen-Anordnung eine Verbindung der Leiterschienen an deren einander zugewandten Seitenflächen vorgesehen sein. Dies kann durch die oben erwähnten Stege oder durch elektrisch isolierenden Kleber erreicht werden.

In einer bevorzugten Ausführungsform der Erfindung trägt die elektrisch isolierende Trägerplatine oder die Folie strombegrenzende Widerstände in den Ansteuerleitungen für die Halbleiterschalter, wobei diese (Gate-)Widerstände zwischen den jeweiligen Steuereingängen und dem Anschluß zur Verbindung mit der Ansteuereinrichtung vorgesehen sind.

Erfindungsgemäß sind wenigstens zwei Halbbrückenbaugruppen der vorstehend beschriebenen Art mechanisch einander zugeordnet sind und elektrisch parallelgeschaltet um eine Halbbrückenanordnung zu bilden. Durch das erfindungsgemäße modulare Konzept ist eine einfache Erweiterung auf höhere Ausgangsleistungen moglich. Durch einfaches Parallelschalten einer entsprechenden Anzahl von Halbbrückenbaugruppen bzw. Erweitern einer Halbbrückenanordnung um zusätzliche Halbbrückenbaugruppen ist es auch möglich, eine höhere Ausgangsleistung bzw. Phasenzahl bereitzustellen.

Die Erfindung betrifft demnach auch eine Leistungsendstufe einer Ansteuereinrichtung für einen mehrphasigen Elektromotor, bei der für jede Phase des Elektromotors eine Halbbrükkenanordnung bereitgestellt ist, wobei die Halbbrückenanordnungen nebeneinander angeordnet sind. In einer bevorzugten Ausführungsform der Erfindung wird eine Leistungsendstufe einer Ansteuereinrichtung für einen mehrphasigen Elektromotor bereitgestellt, wobei eine Steuerungselektronikbaugruppe der Leistungsendstufe räumlich zugeordnet ist und im gleichen Gehäuse angeordnet ist. Damit ist ein besonders kompakter Aufbau einer funktionstüchtigen Gesamtanordnung gegeben, da hierbei sowohl die Steuerungselektronikbaugruppe als auch die Leistungsendstufe mit ihrer Vielzahl an Halbbrückenanordnungen bzw. Halbbrückenbaugruppen im gleichen Kühlmedium untergebracht sind, als auch die Steuerleitungen sehr kurz und störungsunempfindlich geführt sein können.

Die für die Erfindung verwendeten Halbleiter sind vorzugsweise durch schnellschaltende, verlustarme Feldeffekt-Transistoren (FETs) oder durch schnellschaltende, verlustarme bipolare Transistoren mit isoliertem Gateanschluß (IGBTs) gebildet. Dabei können mehrere Paare in Serie geschalteter Halbleiterschalter parallel geschaltet sein. Außerdem können die Halbleiterschalter durch eine große Anzahl von einzelnen Halbleiterschalter-Bauelementen mit jeweils kleinen Schaltleistungen gebildet sein.Durch die Verwendung vieler Halbleiterschalterelemente mit jeweils einer relativ kleinen Schaltleistung, die jedoch einfach parallelschaltbar sind, kann eine gute Kühlung erreicht werden, da die vielen Einzelbauteile gut durch das Kühlmedium erreichbar sind.

In der Zeichnung ist eine bevorzugte Ausführungsform des Erfindungsgegenstandes veranschaulicht.
- Fig. 1: zeigt einen elektrischen Schaltplan einer Halbbrücke;
- Fig. 2: zeigt eine Halbbrückenbaugruppe in einer schematischen Ansicht von oben.
- Fig. 3: zeigt zwei zusammengefügte Halbbrückenbaugruppen aus Fig. 2 in einer schematischen Schnittdarstellung längs der Linie II-II von vorne.

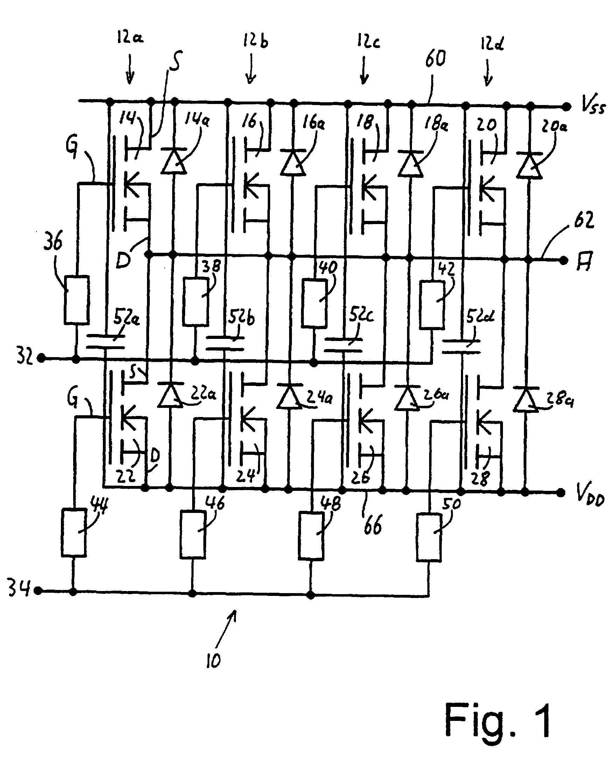

Fig. 1 zeigt eine Halbbrücke 10, die vier parallel geschaltete Paare 12a, 12 b, 12c, 12d von N-Kanal MOSFETs aufweist, die als Halbleiterschalter wirken. Jeweils zwei der MOSFETs 14, 22; 16, 24; 18, 26; 20, 28, die jeweils ein Paar bilden, sind in Serie geschaltet. Jeweils der erste MOSFET 14; 16; 18; 20 jedes Paares liegt mit seinem Source-Anschluß auf einem hohen Spannungspotential V_{SS}, und jeder zweite MOSFET 22; 24; 26; 28 jedes Paares liegt mit seinem Drain-Anschluß auf einem niedrigen Spannungspotential V_{DD}. Dabei sind zur Bildung eines Ausgangs A der Drain-Anschluß jedes der ersten MOSFETs 14; 16; 18; 20 und der Source-Anschluß jedes der zweiten MOSFETs 22; 24; 26; 28 miteinander verbunden. Jeweils ein Steuereingang 32; 34 ist für die Gruppe der ersten MOSFETs 14; 16; 18; 20 bzw. die Gruppe der zweiten MOSFETs 22; 24; 26; 28 vorgesehen, wobei über Gatewiderstände 36; 38; 40; 42 bzw. 44; 46; 48; 50 die Gateanschlüsse der jeweiligen MOSFETs angesteuert werden.

Zwischen dem hohen und dem niedrigen Spannungspotential V_{SS} und V_{DD} ist eine Stützkondensatoranordnung angeordnet, die durch einzelne parallelgeschaltete Stützkondensatoren 52a, 52b, 52c, 52d gebildet ist. Die Ausführung der Kondensatoranordnung 52a, 52b, 52c, 52d ist weiter unten detaillierter beschrieben. Die Ansteuerung der jeweiligen Gruppe der MOSFETs erfolgt mit einem (pulsweitenmodulierten) Steuersignal von mehr als 20 kHz Schaltfrequenz an. Vorzugsweise beträgt die Schaltfrequenz 100 kHz und mehr.

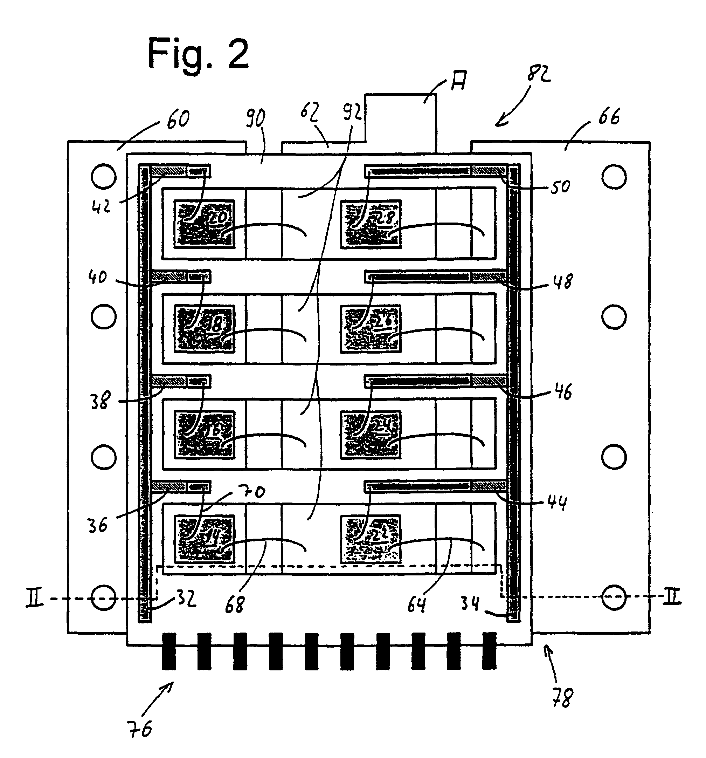

Wie in Fig. 2 gezeigt, sind die ersten MOSFETs 14; 16; 18; 20 mit ihrem Source-Anschluß S auf einer gemeinsamen ersten, mit dem hohen Spannungspotential V_{SS} verbindbaren metallischen Leiterschiene 60 angelötet. Die Leiterschiene 60 hat ein im Querschnitt etwa rechteckiges Profil und ist aus Kupfer oder einem ähnlich gut elektrischen Strom und Wärme leitenden Material hergestellt.

Die zweiten MOSFETs 22; 24; 26; 28 sind mit ihrem Source-Anschluß (S) auf einer gemeinsamen zweiten, den Ausgang A bildenden metallischen Leiterschiene 62 angelötet, wobei die zweite Leiterschiene 62 im Abstand zur ersten Leiterschiene 60 neben dieser angeordnet ist. Auch die zweite Leiterschiene 62 hat ein im Querschnitt etwa rechteckiges Profil und ist aus dem gleichen Material wie die erste Leiterschiene 60 hergestellt.

Die zweiten MOSFETs 22; 24; 26; 28 sind über einen oder mehrere Bond-Drähte 64 jeweils mit ihren Drain-Anschlüssen D mit einer gemeinsamen dritten, mit dem niedrigen Spannungspotential V_{DD} verbindbaren metallischen Leiterschiene 66 verbunden, wobei die dritte Leiterschiene 66 im Abstand zu und neben der zweiten Leiterschiene 62 angeordnet ist.

Die ersten MOSFETs 14; 16; 18; 20 sind über einen oder mehrere Bond-Drähte 68 jeweils mit ihren Drain-Anschlüssen D mit der zweiten Leiterschiene 62 verbunden.

Die Kondensatoranordnung 52 ist durch mehrere mit der ersten und der dritten Leiterschiene 60, 66 durch stufenförmige Anschlußbleche 72, 74 verbundene blockförmige Folienkondensatoren 52 a .. 52d gebildet. An ihren freien Enden weisen die Anschlußbleche 72, 74 Löcher 72a, 74a auf, durch die Schrauben 96, 98 zur Befestigung der Anschlußbleche 72, 74 zwischen den jeweiligen Leiterschienen und Abstandshaltern 86, 88 reichen. Die stufenförmigen Anschlußbleche 72, 74 sind so bemessen, daß die blockförmigen Folienkondensatoren 52a .. 52d die jeweiligen ersten und zweiten Halbleiterschalter derart übergreift, daß sich die Halbleiterschalter räumlich zwischen den entsprechenden Leiterschienen und dem jeweiligen blockförmigen Folienkondensator befinden. Dabei ist zwischen den Halbleiterschaltern und dem Folienkondensator noch ein kleiner Abstand eingehalten, so daß die Kühlflüssigkeit dazwischen hindurchströmen kann. Die Abstandshalter 86, 88 sind so dimensioniert, daß die Folienkondensatoren sie nicht überragen.

Die in Fig. 1 gezeigten Dioden 14a .. 28a sind in der Ausführungsform von Fig. 2 als in die MOSFETs integriert ausgeführt und daher nicht separat gezeigt. Im übrigen wären separate Dioden 14a .. 28a neben den MOSFETs 14 ... 28 ebenfalls auf der ersten bzw. zweiten Leiterschiene 60, 62 angelötet.

Um eine separat herstellbare und handhabbare Einheit einer Halbbrückenbaugruppe bereitzustellen, sind die erste, zweite und dritte Leiterschiene 60, 62, 66 durch eine elektrisch isolierende Trägerplatine 90 mechanisch miteinander fest verbunden. Dazu ist die Trägerplatine 90 an der gleichen Oberfläche wie die Halbleiterschalter auf die Leiterschienen aufgeklebt. Die Trägerplatine 90 dient außerdem der Aufnahme von Verbindungsleitungen 32, 34 zwischen den jeweiligen Steuereingängen G der Halbleiterschalter und den Pins der Anschlußleiste 76 zur Verbindung mit der Ansteuereinrichtung.

Wie in Fig. 2 gezeigt, sind die jeweiligen Steuereingänge G sowie einige Testpins an einer Anschlußleiste 76 an der Trägerplatine 90 zur Verbindung mit einer Ansteuereinrichtung im Bereich einer ersten Stirnseite 78 (in Fig. 2 unten) der Leiterschienen 60, 62, 66 herausgeführt, während der Ausgang A an einen Anschluß 80 zur Verbindung mit einem elektrischen Verbraucher im Bereich einer der ersten Stirnseite 78 gegenüberliegenden, zweiten Stirnseite 82 der zweiten Leiterschiene 62 (in Fig. 2 oben) herausgeführt ist.

Auf der Trägerplatine 90 sind auch Gate-Widerstände 36 .. 50 (siehe Fig. 1) als SMD-Bauteile (surface mounted device) zwischen den jeweiligen Steuereingängen G der MOSFETs und den entsprechenden Pins der Anschlußleiste 76 angeordnet. Die Verbindung der Gate-Widerstände mit den Steuereingängen G der MOSFETs erfolgt ebenfalls über Bond-Drähte 70.

Wie in Fig. 2 zu sehen ist, weist die Trägerplatine 90 rechteckige Aussparungen 92 auf, durch die die Halbleiterschalter bzw. die Dioden hindurchragen. Damit ist der Gesamtaufbau relativ flach.

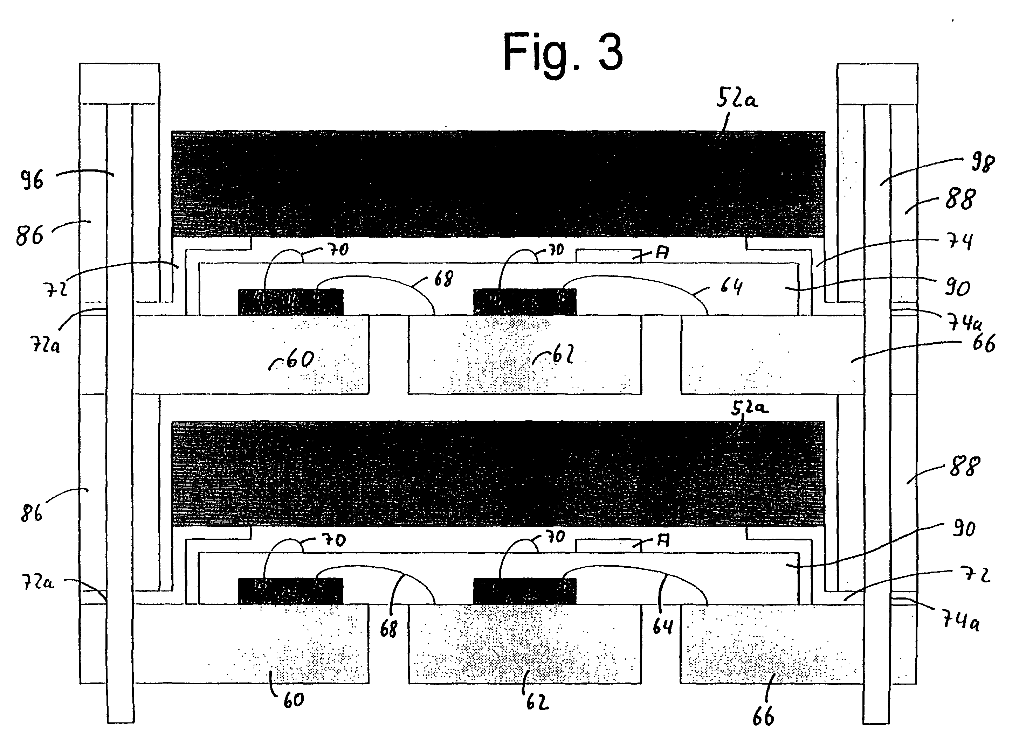

Zur Bildung einer Halbbrückenanordnung können mehrere der vorstehend beschriebenen Halbbrückenbaugruppen miteinander mechanisch fest verbunden und elektrisch parallel geschaltet sein. Dies ist in Fig. 3 veranschaulicht, wobei zwei identisch Halbbrückenbaugruppen übereinandergestapelt und miteinander verschraubt sind. Ersichtlich dienen die äußeren Leiterschienen 60, 66 sowie die dazwischen angeordneten Abstandshalter 86, 88 zur gemeinsamen Stromzuführung für die Halbleiterschalter, während die Ausgänge A der einzelnen Halbbrückenbaugruppen getrennt hintereinander bereitgestellt sind.

Die in Fig. 3 gezeigte Anordnung kann - für jede Phase einer elektrischen Verbindung - über die Anschlußleiste 76 (siehe Fig. 2) mit einer gemeinsamen Steurungselektronikbaugruppe zu einer kompakten Einheit verbunden werden, die in einem gemeinsamen Gehäuse untergebracht ist. Dabei ist das Gehäuse fluiddicht ausgeführt und enthält das inerte Kühlmedium, z.B. einen Fluorchlorkohlenwasserstoff.

## Patentansprüche

1. Halbbrückenbaugruppe zum Schalten elektrischer Leistungen, die in einem eine elektrisch isolierende Kühlflüssigkeit enthaltenden Gehäuse angeordnet ist, und bei der
- wenigstens zwei Halbleiterschalter (14, 22; 24, 18, 26; 20, 28) unter Bildung einer Halbbrücke (12a, 12b, 12c, 12d) in Serie geschaltet sind;
- jeder Halbleiterschalter (14, 22; 24, 18, 26; 20, 28) einen Steuereingang (G) zur Verbindung mit einer Ansteuereinrichtung aufweist;
- der erste Halbleiterschalter (14, 16, 18, 20) mit seinem Source-Anschluß (S) mit einem hohen Spannungspotential (V_{SS}) verbindbar ist;
- der zweite Halbleiterschalter (22, 24, 26, 28) mit seinem Drain-Anschluß (D) mit einem niedrigen Spannungspotential (V_{DD}) verbindbar ist;
- zur Bildung eines Ausgangs (A) der Drain-Anschluß (D) jedes ersten Halbleiterschalters (14, 16, 18, 20) mit dem Source-Anschluß (S) des jeweiligen zweiten Halbleiterschalters (22, 24, 26, 28) verbunden ist; und
- wenigstens eine Kondensatoranordnung (52) zwischen dem hohen und dem niedrigen Spannungspotential (V_{SS}, V_{DD}) angeordnet ist;
**dadurch gekennzeichnet, daß**
- jeweilige erste Halbleiterschalter (14, 16, 18, 20) mit ihrem Source-Anschluß (S) auf einer gemeinsamen ersten, mit dem hohen Spannungspotential (V_{SS}) verbindbaren metallischen Leiterschiene (60) angeordnet sind;
- jeweilige zweite Halbleiterschalter (22, 24, 26, 28) mit ihrem Source-Anschluß (S) auf einer gemeinsamen zweiten, den Ausgang (A) bildenden metallischen Leiterschiene (62) angeordnet sind, wobei die zweite Leiterschiene (62) im Abstand zur ersten Leiterschiene (60) neben dieser angeordnet ist;
- jeder zweite Halbleiterschalter (22, 24, 26, 28) mit seinem Drain-Anschluß (D) mit einer gemeinsamen dritten, mit dem niedrigen Spannungspotential (V_{DD}) verbindbaren metallischen Leiterschiene (66) verbunden ist, die im Abstand zu und neben der ersten und der zweiten Leiterschiene (60, 62) angeordnet ist;
- die Kondensatoranordnung (52) einen mit der ersten und der dritten Leiterschiene (60, 66) durch Anschlüsse verbundenen Stützkondensator (52a .. 52d) aufweist, der den ersten und zweiten Halbleiterschalter (14, 22; 24, 18, 26; 20, 28) derart übergreift, daß sich die Halbleiterschalter räumlich zwischen den entsprechenden Leiterschienen (60, 66) und dem Stützkondensator (52a .. 52d) befinden;
- der Steuereingang (G) einen Anschluß (76) zur Verbindung mit der Ansteuereinrichtung im Bereich einer ersten Stirnseite (78) der Leiterschienen (60, 62, 68) aufweist, und
- der Ausgang (A) einen Anschluß zur Verbindung mit einem elektrischen Verbraucher im Bereich einer der ersten gegenüberliegenden, zweiten Stirnseite (82) der zweiten Leiterschiene (62) aufweist.

2. Halbbrückenbaugruppe nach Anspruch 1, **dadurch gekennzeichnet, daß** an der ersten und/oder der dritten Leiterschiene (60, 66) elektrische leitende Abstandshalter (86, 88) angeordnet sind.

3. Halbbrückenbaugruppe nach Anspruch 1, **dadurch gekennzeichnet, daß** die erste, zweite und dritte Leiterschiene (60, 62, 66) durch eine elektrisch isolierende Trägerplatine (62) mechanisch miteinander fest verbunden sind.

4. Halbbrückenbaugruppe nach Anspruch 1, **dadurch gekennzeichnet, daß** die erste, zweite und dritte Leiterschiene (60, 62, 66) durch elektrisch isolierende Stege, die zwischen den einzelnen Leiterschienen angeordnet sind, mechanisch miteinander fest verbunden sind.

5. Halbbrückenbaugruppe nach Anspruch 4, **dadurch gekennzeichnet, daß** an den Leiterschienen (60, 62, 66) eine elektrisch isolierende Folie mit Verbindungsleitungen zwischen den jeweiligen Steuereingängen und dem Anschluß zur Verbindung mit der Ansteuereinrichtung angeordnet ist.

6. Halbbrückenbaugruppe nach Anspruch 3, **dadurch gekennzeichnet, daß** die elektrisch isolierende Trägerplatine (62) Verbindungsleitungen zwischen den jeweiligen Steuereingängen und dem Anschluß zur Verbindung mit der Ansteuereinrichtung aufweist.

7. Halbbrückenbaugruppe nach Anspruch 3 oder 5, **dadurch gekennzeichnet, daß** die elektrisch isolierende Trägerplatine oder die Folie Gate-Widerstände trägt, die zwischen den jeweiligen Steuereingängen und dem Anschluß zur Verbindung mit der Ansteuereinrichtung vorgesehen sind.

8. Halbbrückenanordnung, **dadurch gekennzeichnet, daß** wenigstens zwei Halbbrückenbaugruppen nach einem oder mehreren der vorhergehenden Ansprüche mechanisch einander zugeordnet sind und elektrisch parallel geschaltet sind.

9. Leistungsendstufe einer Ansteuereinrichtung für einen mehrphasigen Elektromotor, mit Einrichtungen zur Speisung jeder Phase mit elektrischer Leistung, wobei die Speiseeinrichtungen für jede Phase eine Halbbrückenanordnung zum Schalten der elektrischen Leistung umfassen,
**dadurch gekennzeichnet, daß**
die Halbbrückenanordnungen Halbbrückenanordnungen nach Anspruch 8 sind, wobei die Halbbrückenanordnungen nebeneinander angeordnet sind.

10. Leistungsendstufe einer Ansteuereinrichtung für einen mehrphasigen Elektromotor nach Anspruch 9, **dadurch gekennzeichnet, daß** eine Steuerungselektronikbaugruppe der Leistungsendstufe räumlich zugeordnet ist und im gleichen Gehäuse angeordnet ist.

11. Halbbrückenbaugruppe nach einem oder mehreren der vorhergehenden Ansprüche 1-7, **dadurch gekennzeichnet, daß** die Halbleiterschalter (14, 22; 24, 18, 26; 20, 28) durch schnellschaltende, verlustarme Feldeffekt-Transistoren (FETs) oder durch schnellschaltende, verlustarme bipolare Transistoren mit isoliertem Gateanschluß (IGBTs) gebildet sind.

12. Halbbrückenbaugruppe nach einem oder mehreren der vorhergehenden Ansprüche 1-7, **dadurch gekennzeichnet, daß** mehrere Paare in Serie geschalteter Halbleiterschalter parallel geschaltet sind.

13. Halbbrückenbaugruppe nach einem oder mehreren der vorhergehenden Ansprüche 1-7, **dadurch gekennzeichnet, daß** die Halbleiterschalter durch eine große Anzahl von einzelnen Halbleiterschalter-Bauelementen mit jeweils kleinen Schaltleistungen gebildet sind.

## Claims

1. A half-bridge module for the switching of electrical powers, which is arranged in a housing containing an electrically insulating cooling liquid and in which
- at least two semiconductor switches (14, 22; 24; 18, 26; 20, 28) are connected in series, forming a half-bridge (12a, 12b, 12c, 12d) ;
- each semiconductor switch (14, 22; 24; 18, 26; 20, 28) comprises a control input (G) for connection to a triggering device;
- the first semiconductor switch (14, 16, 18, 20) is capable of being connected by its source terminal (S) to a high voltage potential (V_{SS});
- the second semiconductor switch (22, 24, 26, 28) is capable of being connected by its drain terminal (D) to a low voltage potential (V_{DD});
- for the purpose of forming an output (A), the drain terminal (D) of each first semiconductor switch (14, 16, 18, 20) is connected to the source terminal (S) of the respective second semiconductor switch (22, 24, 26, 28); and
- at least one capacitor arrangement (52) is arranged between the high and the low voltage potentials (V_{SS}, V_{DD}) ;
**characterised in that**
- respective first semiconductor switches (14, 16, 18, 20) are arranged with their source terminal (S) on a common first metallic conductor rail (60) which is capable of being connected to the high voltage potential (V_{SS}) ;
- respective second semiconductor switches (22, 24, 26, 28) are arranged with their source terminal (S) on a common second metallic conductor rail (62) constituting the output (A), the second conductor rail (62) being arranged alongside the first conductor rail (60), spaced therefrom;
- each second semiconductor switch (22, 24, 26, 28) is connected by its drain terminal (D) to a common third metallic conductor rail (66) which is capable of being connected to the low voltage potential (V_{DD}) and is arranged alongside the first and second conductor rails (60, 62), spaced therefrom;
- the capacitor arrangement (52) comprises a backup capacitor (52a .. 52d) which is connected to the first and third conductor rails (60, 66) by terminals and which overlaps the first and second semiconductor switches (14, 22; 24; 18, 26; 20, 28) in such a manner that the semiconductor switches are spatially located between the corresponding conductor rails (60, 66) and the backup capacitor (52a .. 52d);
- the control input (G) comprises a terminal (76) for connection to the triggering device in the region of a first front side (78) of the conductor rails (60, 62, 68), and
- the output (A) comprises a terminal for connection to an electrical consumer in the region of a second front side (82) of the second conductor rail (62) located opposite the first front side.

2. The half-bridge module according to Claim 1,
**characterised in that** electrically conducting spacers (86, 88) are arranged on the first and/or third conductor rails (60, 66).

3. The half-bridge module according to Claim 1,
**characterised in that** the first, second and third conductor rails (60, 62, 66) are mechanically firmly connected to one another by an electrically insulating carrier board (62).

4. The half-bridge module according to Claim 1,
**characterised in that** the first, second and third conductor rails (60, 62, 66) are mechanically firmly connected to one another by electrically insulating crossmembers which are arranged between the individual conductor rails.

5. The half-bridge module according to Claim 4,
**characterised in that** an electrically insulating foil with interconnecting lines between the respective control inputs and the terminal for connection to the triggering device is arranged on the conductor rails (60, 62, 66).

6. The half-bridge module according to Claim 3,
**characterised in that** the electrically insulating carrier board (62) comprises interconnecting lines between the respective control inputs and the terminal for connection to the triggering device.

7. The half-bridge module according to Claim 3 or 5,
**characterised in that** the electrically insulating carrier board or the foil carries gate resistors which are provided between the respective control inputs and the terminal for connection to the triggering device.

8. A half-bridge arrangement, **characterised in that** at least two half-bridge modules according to one or more of the preceding claims are assigned to one another mechanically and are electrically connected in parallel.

9. A power output stage of a triggering device for a multiphase electric motor, having devices for feeding each phase with electrical power, the feeding devices for each phase comprising a half-bridge arrangement for switching the electrical power,
**characterised in that**
the half-bridge arrangements are half-bridge arrangements according to Claim 8 with the half-bridge arrangements being arranged alongside one another.

10. The power output stage of a triggering device for a multiphase electric motor according to Claim 9, **characterised in that** a control-electronics module is spatially assigned to the power output stage and arranged in the same housing.

11. The half-bridge module according to one or several of preceding claims 1-7, **characterised in that** the semiconductor switches (14, 22; 24; 18, 26; 20, 28) are constituted by fast-switching, low-loss field-effect transistors (FETs) or by fast-switching, low-loss bipolar transistors with insulated gate terminal (IGBTs).

12. The half-bridge module according to one or several of preceding claims 1-7, **characterised in that** several pairs of semiconductor switches connected in series are connected in parallel.

13. The half-bridge module according to one or several of the preceding claims, **characterised in that** the semiconductor switches are constituted by a large number of individual semiconductor switch components with, in each case, low switching capacities.

## Revendications

1. Bloc demi-pont pour la commutation de puissances électriques qui est disposé dans un boîtier contenant un liquide de refroidissement isolant électrique et dans lequel
- au moins deux commutateurs à semi-conducteur (14, 22; 24, 18, 26; 20, 28) sont montés en série de façon à former un demi-pont (12a, 12b, 12c, 12d);
- chaque commutateur à semi-conducteur (14, 22; 24, 18, 26; 20, 28) présente une entrée de commande (G) pour la liaison avec un dispositif de commande;
- le premier commutateur à semi-conducteur (14, 16, 18, 20) peut être relié par sa connexion de source (S) à un potentiel de tension élevé (V_{SS});
- le deuxième commutateur à semi-conducteur (22, 24, 26, 28) peut être relié par sa connexion de drain (D) à un potentiel de tension faible (V_{DD});
- pour former une sortie (A) la connexion de drain (D) de chaque premier commutateur à semi-conducteur (14, 16, 18, 20) est reliée à la connexion de source (S) du deuxième commutateur à semi-conducteur respectif (22, 24, 26, 28); et
- au moins un dispositif à condensateur (52) est disposé entre les potentiels de tension élevé et faible (V_{SS}, V_{DD})
**caractérisé en ce que**
- chaque premier commutateur à semi-conducteur respectif (14, 16, 18, 20) est disposé par sa connexion de source (S) sur une première ligne conductrice commune (60) pouvant être reliée au potentiel de tension élevé (V_{SS});
- chaque deuxième commutateur à semi-conducteur respectif (22, 24, 26, 28) est disposé par sa connexion de source (S) sur une deuxième ligne conductrice métallique commune (62) formant la sortie (A), la deuxième ligne conductrice (62) étant disposée avec espacement à côté de la première ligne conductrice (60);
- chaque deuxième commutateur à semi-conducteur (22, 24, 26, 28) est relié par sa connexion de drain (D) à une troisième ligne conductrice métallique commune (66) pouvant être reliée au potentiel de tension faible (V_{DD}) qui est disposée avec espacement et à côté des première et deuxième lignes conductrices (60, 62);
- le dispositif à condensateur (52) présente un condensateur d'assistance (52a .. 52d) relié aux première et troisième lignes conductrices (60, 66) par des jonctions, qui chevauche les premier et deuxième commutateurs à semi-conducteur (14, 22; 24, 18, 26; 20, 28) de telle manière que les commutateurs à semi-conducteur se trouvent spatialement entre les lignes conductrices correspondantes (60, 66) et le condensateur d'assistance (52a .. 52d);
- l'entrée de commande (G) présente une connexion (76) pour la liaison avec le dispositif de commande dans la zone d'une première face frontale (78) des lignes conductrices (60, 62, 68), et
- la sortie (A) présente une connexion pour la liaison avec un appareil consommateur d'électricité dans la zone d'une deuxième face frontale (82) opposée à la première de la deuxième ligne conductrice (62).

2. Bloc demi-pont selon la revendication 1, **caractérisé en ce que** des moyens d'espacement conducteurs (86, 88) sont disposés au premier et / ou à la troisième ligne conductrice (60, 66).

3. Bloc demi-pont selon la revendication 1, **caractérisé en ce que** les première, deuxième et troisième lignes conductrices (60, 62, 66) sont reliées mécaniquement entre elles de façon fixe par une platine de support (62) électriquement isolante.

4. Bloc demi-pont selon la revendication 1, **caractérisé en ce que** les première, deuxième et troisième lignes conductrices (60, 62, 66) sont reliées mécaniquement entre elles de façon fixe par des barrettes électriquement isolantes qui sont disposées entre les différentes lignes conductrices.

5. Bloc demi-pont selon la revendication 4, **caractérisé en ce qu'**aux lignes conductrices (60, 62, 66), une feuille isolante électriquement possédant des lignes de raccordement est disposée entre les entrées de commande respectives et la connexion de raccordement pour établir une liaison avec le dispositif de commande.

6. Bloc demi-pont selon la revendication 3, **caractérisé en ce que** la platine de support (62) isolante électriquement présente des lignes de connexion entre les entrées de commande respectives et le raccordement de connexion avec le dispositif de commande.

7. Bloc demi-pont selon la revendication 3 ou 5, **caractérisé en ce que** la platine ou la feuille de support isolante électriquement porte des résistances de grille qui sont prévues entre les entrées de commande respectives et le raccordement de connexion avec le dispositif de commande.

8. Moyen demi-pont, **caractérisé en ce qu'**au moins deux blocs de pont selon une ou plusieurs des revendications précédentes sont associés mécaniquement l'un avec l'autre et montés électriquement en parallèle.

9. Etage de puissance final d'un dispositif de commande pour moteur électrique polyphasé comprenant des moyens pour l'alimentation de chaque phase avec une puissance électrique, dans lequel les moyens d'alimentation comprennent pour chaque phase un moyen demi-pont pour coupler la puissance électrique, **caractérisé en ce que** les moyens demi-pont sont des moyens demi-pont selon la revendication 8, les moyens demi-pont étant disposés l'un à côté de l'autre.

10. Etage de puissance final d'un dispositif de commande pour moteur électrique polyphasé selon la revendication 9, **caractérisé en ce qu'**un bloc électronique de commande est associé spatialement à l'étage final de puissance et est disposé dans le même boîtier.

11. Bloc demi-pont selon l'une ou plusieurs des revendications précédentes 1-7, **caractérisé en ce que** les commutateurs à semi-conducteur (14, 22; 24, 18, 26; 20, 28) sont des transistors à effet de champ à commutation rapide et à faibles pertes (FETs) ou des transistors bipolaires à commutation rapide et à faibles pertes à raccord de grille isolé (IGBTs).

12. Bloc demi-pont selon l'une ou plusieurs des revendications précédentes **caractérisé en ce que** plusieurs paires de commutateurs à semi-conducteur montés en série sont montées en parallèle.

13. Bloc demi-pont selon l'une ou plusieurs des revendications précédentes 1-7, **caractérisé en ce que** les commutateurs à semi-conducteur sont formés d'un grand nombre de composants commutateurs à semi-conducteur individuels présentant respectivement de petites puissances de coupure.
